# EUROPEAN PATENT SPECIFICATION

(11) **EP 1 939 927 B1**
(45) Date of publication and mention of the grant of the patent: **23.01.2019**
(21) Application number: 07024695.4
(22) Date of filing: 20.12.2007
(51) Int. Cl.: H01L 21/20, H01L 21/316, H01L 21/762, H01L 21/02, H01L 21/304

(54) **Method of manufacturing a bonded wafer**
Verfahren zur Herstellung eines gebondeten Wafers
Procédé de production de plaquette collée

(30) Priority: 26.12.2006 JP 2006350138; 06.11.2007 JP 2007287991
(43) Date of publication of application: 02.07.2008
(73) Proprietor: SUMCO CORPORATION, Tokyo 105-8634 (JP)
(72) Inventor: Okuda, Hidehiko SUMCO CORPORATION, Tokyo 105-8634 (JP); Kusaba, Tatsumi SUMCO CORPORATION, Tokyo 105-8634 (JP); Endo, Akihiko SUMCO CORPORATION, Tokyo 105-8634 (JP)
(74) Representative: Godemeyer Blum Lenze Patentanwälte Partnerschaft mbB - werkpatent

(56) References cited:
- EP-A1- 1 662 555
- GB-A- 2 347 265
- US-A1- 2005 118 789
- US-A1- 2006 154 442

## Description

### BACKGROUND OF THE INVENTION

### FIELD OF THE INVENTION

The present invention relates to a method of manufacturing a bonded silicon wafer such as an SOI wafer having a thin BOX layer and a DSB wafer.

### DISCUSSION OF THE BACKGROUND

In contrast to conventional silicon wafers, silicon-on-insulator (SOI) wafers afford the advantages of device isolation, reduced parasitic capacitance between device and substrate, and the ability to form three-dimensional structures. Utilizing these advantages, SOI wafers have been employed in high-speed, low power consumption LSIs (large scale integration integrated circuit) and the like in recent years.

A conventional SOI wafer is comprised of two wafers bonded through a relatively thick (for example, about 1,500 Angstrom) oxide film. However, with the use of new devices in recent years, demand has been increasing for SOI wafers having thin oxide films and direct silicon bonding (DSB) wafers in which two wafers are directly bonded without an oxide film.

It is known that multiple voids form on the bonding surface when two wafers are directly bonded to manufacture a DSB wafer. To reduce these voids, Japanese Unexamined Patent Publication (KOKAI) No. 2006-156770 or English language family member EP 1 818 971 A1 proposes a method in which the two wafers are bonded through a thin oxide film, after which a heat treatment is conducted to remove the interface oxide film. Document EP 1 662 555 discloses a method for producing SOI wafer. The said method involves splitting a bonded structure along an implanted layer.

Normally, a vertical furnace is used to form a BOX oxide film. However, when employing a vertical furnace, treatment for at least several tens of minutes is requited to produce an oxide film. Further, in vertical furnaces, the higher the oxidation temperature, the more rapid the rate of growth of the oxide film, making it difficult to control the film thickness. Accordingly, forming the thin oxide films that have been in ever greater demand in recent years with uniform thickness in vertical ovens requires low-temperature processing. However, low-temperature processing presents the risks of the growth of precipitation nuclei in the wafer and excessive precipitation, resulting in the problem of failed lithography and the like in device processing.

### SUMMARY OF THE INVENTION

An aspect of the present invention provides for both a high-quality SOI wafer having a thin BOX oxide film with a uniform thickness, and a high-quality DSB wafer.

The present inventors conducted extensive research, resulting in the discovery that by rapidly raising the temperature in an oxidizing atmosphere and heating a wafer to a prescribed temperature to form an oxide film, it was possible to rapidly form a thin BOX oxide film of equal to or less than 30 nm in thickness, or even an ultra thin BOX oxide film of equal to or less than 2 nm in thickness with a uniform thickness, for example, and to reduce the bulk micro defects (BMDs) in the wafer; the present invention was devised on this basis.

An aspect of the present invention relates to a method of manufacturing a bonded silicon wafer comprising:
an oxidation step in which an oxide film is formed on at least one surface of a base wafer,
a bonding step in which the base wafer on which the oxide film has been formed is bonded wafer, wherein the oxygen concentration for the base wafer and the top wafer is 8 x E +17 to 14 x E+17 atoms/cm³, and
a thinning step in which the top wafer included in the bonded wafer is thinned, wherein
the above oxidation step comprises heating the base wafer to a heating temperature ranging from 800 to 1300 °C at a rate of temperature increase ranging from 50 to 100 °C/second in an oxidizing atmosphere, and
the above bonding step is carried out so as to position the oxide film formed in the above oxidation step at an interface of the top wafer and the base wafer.

In one embodiment, the oxidation step can be carried out in a Rapid Thermal Processor.

In one embodiment, the oxidation step can be carried out so as to form an oxide film on at least one surface of the base wafer to the extent that the total thickness of the oxide film positioned at the interface is equal to or less than 30 nm.

In one embodiment, the heating temperature in the oxidation step can range from 1000 to 1200°C.

In one embodiment, the oxidation step can comprise holding the base wafer for 1 to 3 minutes at the heating temperature in the oxidation step.

In one embodiment, the oxidation step can further comprise lowering a temperature at a rate of temperature reduction ranging from 50 to 100 °C/second.

In one embodiment, the thinning step can be conducted by, prior to the bonding step, implanting light element ions into a top wafer to form an ion implantation layer in the top wafer, and following the bonding step, subjecting the bonded wafer to heat treatment to separate a portion of the top wafer from the bonded wafer at the ion implantation layer as boundary.

In one embodiment, the thinning step can be conducted by, prior to the bonding step, implanting oxygen ions into a top wafer to form an ion implantation layer in the top wafer, and following the bonding step, removing a portion of the top wafer from the bonded wafer at the ion implantation layer as boundary by grinding, polishing and/or etching.

In one embodiment, the method of manufacturing can further comprise removing the oxide film present at the interface by subjecting the bonded wafer to heat treatment in a non-oxidizing atmosphere.

The present invention permits the rapid manufacturing of a BOX oxide film of uniform thickness. By rapidly conducting the oxidation treatment at a high temperature, it is possible to reduce the BMD density in the wafer.

According to the present invention, voids generated in the bonding step and in the step of thinning the top wafer can be reduced, thereby providing a high-quality bonded wafer.

Other exemplary embodiments and advantages of the present invention may be ascertained by reviewing the present disclosure and the accompanying drawings.

### BRIEF DESCRIPTION OF THE DRAWINGS

The present invention will be described in the following text by the exemplary, non-limiting embodiments shown in the figures, wherein:

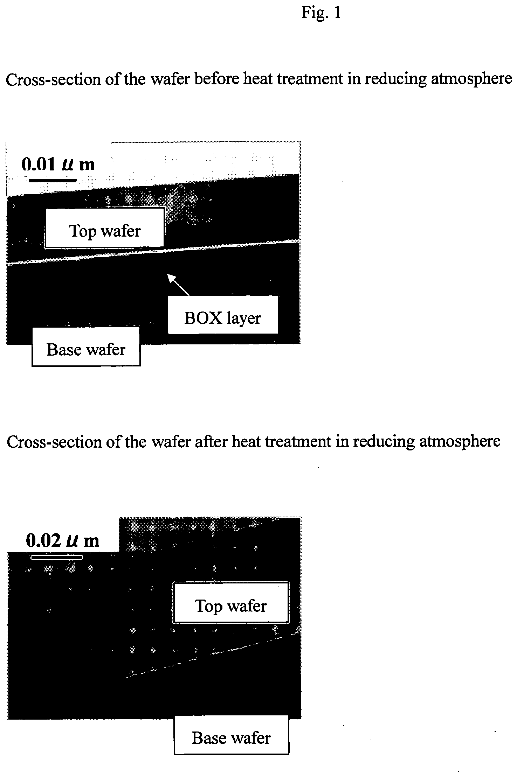

Fig. 1 shows TEM images of wafer cross-sections before and after the heat treatment in Example 7.

### DESCRIPTIONS OF THE EMBODIMENTS

The following preferred specific embodiments are, therefore, to be construed as merely illustrative, and non-limiting to the remainder of the disclosure in any way whatsoever. In this regard, no attempt is made to show structural details of the present invention in more detail than is necessary for fundamental understanding of the present invention; the description taken with the drawings making apparent to those skilled in the art how several forms of the present invention may be embodied in practice.

The method of manufacturing a bonded silicon wafer of the present invention comprises:
(1) an oxidation step in which an oxide film is formed on at least one surface of a base wafer,
(2) a bonding step in which the base wafer on which the oxide film has been formed is bonded to a top wafer to form a bonded wafer, wherein the oxygen concentration for the base wafer and the top wafer is 8 x E+17 to 14 x E+17 atoms/cm³, and
(3) a thinning step in which the top wafer included in the bonded wafer is thinned.

The oxidation step comprises heating the base wafer to a heating temperature ranging from 800 to 1300 °C at a rate of temperature increase ranging from 50 to 100 °C/second in an oxidizing atmosphere, and the bonding step is carried out so as to position the oxide film formed in the oxidation step at an interface of the top wafer and the base wafer.

Each of these steps will be described below.

### (1) Oxidation step

In the method of manufacturing a bonded wafer of the present invention, an oxide film is formed on at least one surface of a base wafer. The oxide film that is formed in this step is positioned at the interface of two wafers in a subsequent bonding step. It is thus possible to obtain an SOI wafer having a buried oxide film.

Two silicon wafers sliced from a single boron-doped silicon ingot grown by the CZ method or the like can be employed as the bonded wafers, for example. When obtaining a DSB wafer by removing the oxide film after bonding two wafers through an oxide film, a silicon wafer is employed as the base wafer and a wafer that is heterogeneous with respect to the base wafer or a silicon wafer of different orientation from the base wafer can be employed as the top wafer. Further, to reduce BMDs, described further below, it is desirable to bond wafers of reduced oxygen concentration. The oxygen concentration for both the base wafer and top wafer is 8 x E + 17 atoms/cm³ to 14 x E + 17 atoms/cm³, more preferably 10 x E + 17 atoms/cm³ to 12 x E + 17 atoms/cm³.

The oxidation step comprises heating the wafer on which the oxide film is to be formed to a heating temperature ranging from 800 to 1300 °C at a rate of temperature increase ranging from 50 to 100 °C/second in an oxidizing atmosphere.

The upper limit of the heating temperature in a vertical oven (resistance heating, batch type) commonly employed in the forming of BOX oxide films is about 1,200°C and the rate of temperature increase is generally about 10 to 20°C/minute. Thus, approximately several tens of minutes are required to form a BOX oxide film. Further, as stated above, it is necessary to conduct the treatment at low temperature to form a thin oxide film of uniform thickness in a vertical furnace. However, the use of low-temperature processing causes SiO₂ precipitation nuclei to grow inside the wafer, resulting in excessive precipitation. Thus, bulk micro defects (BMDs) increase in the wafer, potentially causing lithographic failure in device processing. In a conventionally employed vertical furnace, it is difficult to achieve both the formation of an oxide film of uniform thickness (particularly a thin oxide film) and a reduced BMD density.

By contrast, in the present invention, heating is conducted to a temperature of 800 to 1,300°C at a rate of temperature increase that is much more rapid that when employing a vertical oven. Thus, it is possible to rapidly form a BOX film of uniform film thickness without causing an increase in the BMD density.

When forming a thin oxide film at the above rate of temperature increase of less than 1°C/second, it is difficult to maintain film thickness uniformity. Additionally, when the rate of temperature increase exceeds 300°C/second, there is a risk of generating slips in the wafer. When the heating temperature is less than 800°C, it becomes difficult to form a thin oxide film of uniform thickness. When exceeding 1,300°C, slips may be generated in the wafer.

The oxidation step can be conducted by RTP oxidation in a lamp-type Rapid Thermal Processor (RTP). In an RTP, a lamp such as an infrared lamp is employed to heat a single wafer, permitting a rapid temperature increase. The use of an RTP permits a rapid temperature increase and reduction, permitting heating at the aforementioned rate of temperature increase, and thus permitting the rapid formation of an oxide film of uniform thickness without increasing the BMD density.

The above oxidation step is a suitable method for forming a thin, uniform BOX oxide film, and preferably applied, for example, when obtaining a bonded wafer having a BOX oxide film thickness of equal to or less than 30 nm, further, equal to or less than 2 nm, or, for example, 0.5 to 2 nm.

It is desirable to adjust heating and cooling conditions such as the rate of temperature increase and reduction, the temperature and maintenance period following heating in the oxidation step to effectively reduce the BMD. The following heating and cooling process, for example, is desirable to form an oxide film (preferably of equal to or less than 2 nm in thickness) on the base wafer: heating to a temperature of 800 to 1,300°C, preferably 800 to 1,200°C, more preferably 1,000 to 1,200°C, at a rate of temperature increase of 50 to 100°C/second, more preferably 75 to 90°C/second; maintaining this heating temperature for 1 to 3 minutes, preferably 1 to 2 minutes; and reducing the temperature to 500 to 700°C, preferably 500 to 600°C, at a rate of temperature reduction of 50 to 100°C/second, preferably 75 to 90°C/second. It is possible to preheat the oven before conducting the oxidation step. The preheat temperature is, for example, about 500 to 700°C.

The thickness of the oxide film that is formed can be controlled by adjusting the heating and cooling conditions and the concentration of oxygen in the oxidizing atmosphere. The concentration of oxygen in the oxidizing atmosphere can be 10 to 100 percent, preferably 50 to 100 percent. Examples of gases that may also be present are nitrogen and argon; there is no specific limitation in this regard.

### (2) Bonding step

Following the oxidation step, the top wafer and base wafer are bonded so that the oxide film that has been formed is positioned between the two wafers. The bonding step may be conducted at room temperature using a jig such as that commonly employed in wafer bonding, for example. The two wafers may be adhered without employing adhesive or the like by polishing the surfaces of both wafers to a mirror surface.

### (3) Thinning step

Following the bonding step, a thinning step is conducted in which the top wafer is thinned. The thinning step can be conducted by an ion implantation separation method, grinding, polishing, etching, or the like. To highly adjust the thickness of the remaining top wafer when thinning the top wafer, the use of an ion implantation separation method or a thinning method employing an oxygen ion-implantation layer, described further below, is desirably employed. When employing an ion implantation separation method, ions are implanted prior to the bonding step and the wafer is heat treated following the bonding step to separate a portion of the top wafer at the ion implantation layer as boundary.

In the above ion implantation, light element ions (such as hydrogen ions, noble gas ions, or a mixture of hydrogen and noble gas ions) are implanted into the top wafer to form an ion implantation layer in the top wafer. The ion implantation can be conducted using a known ion implantation device. The acceleration voltage during ion implantation can be 10 to 100 keV, for example. When productivity is taken into account, a low level of ion implantation is desirable. However, an excessively low level renders separation difficult during the subsequent heat treatment. Based on these considerations, the level of ion implantation is, for example, 2 e¹⁶ to 1 e¹⁷/cm², preferably 5 e¹⁶ to 1 e¹⁷/cm².

The temperature of the heat treatment for separating the top wafer is generally equal to or higher than 300°C, preferably 350 to 500°C. When the temperature of the heat treatment falls within this range, air bubbles can develop in the ion implantation layer, forming a continuous layer that causes separation to take place at the ion implantation layer as boundary. The heat treatment period can be from one minute to one hour, and is preferably 1 to 30 minutes. The rate of temperature increase is, for example, 0.5 to 10°C/minute, preferably 1 to 5°C/minute. The heat treatment can be conducted using a known heat treatment device.

In the thinning step employing a thinning method using an oxygen ion implantation layer, oxygen ions are implanted into the top wafer prior to bonding to form an ion implantation layer in the top wafer. After the bonding step, grinding, polishing, and/or etching is used to remove a portion of the top wafer at the ion implantation layer as boundary.

Following the thinning step, the bonded wafers can be heat treated in a non-oxidizing atmosphere to remove the oxide film present at the bonding interface. This is done because the heat treatment causes oxygen in the wafers to diffuse outward, lowering the concentration and causing the oxide film present in this region of lowered oxygen concentration to diffuse into the wafer. In this manner, a wafer (DSB wafer) comprised of two directly bonded wafers can be obtained.

The non-oxidizing atmosphere is, for example, a reducing atmosphere or an inert atmosphere, such as a nitrogen atmosphere, argon atmosphere, or hydrogen atmosphere. The conditions of the above heat treatment are desirably set by taking into account the thickness of the oxide film present at the wafer interface and the concentration of oxygen in the wafer. The heat treatment temperature, for example, can be 1,000 to 1,200°C, and is desirably 1,100 to 1,150°C. The heat treatment period is, for example, 0.5 to 2 hours, desirably 1 to 2 hours. The top wafer can be rendered a defect-free layer by the above heat treatment. Furthermore, the BMD density of the interior of the base wafer can be reduced by the above oxidation treatment. Therefore, it becomes possible to obtain a high-quality DSB wafer.

Subsequently, the top wafer lateral surfaces and base wafer lateral surfaces of the bonded wafer obtained can be polished to obtain a bonded wafer of desired thickness.

As set forth above, the method of manufacturing a bonded wafer of the present invention can be used to achieve a thin oxide film of a uniform thickness of equal to or less than 30 nm, for example, or even equal to or less than 2 nm, and to reduce the BMD density in the base wafer to equal to or less than 1 E+5/cm², for example, or even 1 E+2/cm² to 1 E +5/cm². The BMD density can be measured by the light etching method.

### EXAMPLES

The present invention will be described in detail below based on examples. However, the present invention is not limited to the examples.

### [Example 1]

### (1) Preparation of top and base wafers

Two silicon wafers measuring 725 micrometers in thickness, having a diameter of 200 mm, a resistivity of 20 Ohms ·cm, and an oxygen concentration of 12 E+17/cm³ were prepared by slicing from a boron-doped silicon ingot grown by the CZ method. Subsequently, the silicon wafers were polished to a mirror finish by a known method. One of the silicon wafers was employed as the top wafer and the other as the base wafer.

### (2) Formation of a BOX oxide film

The variation and average value of the thickness of an oxide film -- formed on the surface of the silicon wafer being employed as base wafer with an RTP (made by Mattson Corp., 100 percent oxygen atmosphere in the processor) by increasing the temperature from 600°C to 900°C at 50°C/second, maintaining 900°C for one minute, and then decreasing the temperature to 600°C at 50°C/second -- were evaluated with a reflective-type film thickness measuring device. Table 1 gives the difference between the maximum value and minimum value of the film thickness (film thickness range) at 121 points on the surface, and the average film thickness.

### (3) Ion implantation

The silicon wafer being employed as top wafer was set in the vacuum chamber of an ion implantation device and rotation was begun. Under conditions of 40 keV and 5.0 E 16/cm², implantation was conducted with a hydrogen ion beam to form an ion implantation layer.

### (4) Bonding

The top wafer and base wafer were bonded so that the BOX oxide film was positioned at the interface. The BMD density in the base wafer of the bonded wafer obtained was evaluated by the light etching method. The results are shown in Table 1.

### [Example 2]

A bonded wafer was prepared by the same method as in Example 1 with the exception that a BOX oxide film was formed on the surface of the silicon wafer being employed as the base wafer with an RTP (made by Mattson Corp., 100 percent oxygen atmosphere in the processor) by increasing the temperature from 600°C to 1,100°C at 50°C/second, maintaining 1,100°C for one minute, and then decreasing the temperature to 600°C at 50°C/second.

### [Example 3]

A bonded wafer was prepared by the same method as in Example 1 with the exception that the oxygen concentration of the top and base wafers was changed to 13 E + 17/cm³.

### [Example 4]

A bonded wafer was prepared by the same method as in Example 3 with the exception that a BOX oxide film was formed on the surface of the silicon wafer being employed as the base wafer with an RTP (made by Mattson Corp., 100 percent oxygen atmosphere in the processor) by increasing the temperature from 600°C to 1,100°C at 50°C/second, maintaining 1,100°C for one minute, and then decreasing the temperature to 600°C at 50°C/second.

### [Example 5]

A bonded wafer was prepared by the same method as in Example 1 with the exception that the oxygen concentration of the top and base wafers was changed to 14 E + 17/cm³.

### [Example 6]

A bonded wafer was prepared by the same method as in Example 5 with the exception that a BOX oxide film was formed on the surface of the silicon wafer being employed as the base wafer with an RTP (made by Mattson Corp., 100 percent oxygen atmosphere in the processor) by increasing the temperature from 600°C to 1,100°C at 50°C/second, maintaining 1,100°C for one minute, and then decreasing the temperature to 600°C at 50°C/second.

### [Comparative Example 1]

A bonded wafer was prepared by the same method as in Example 1 with the exception that a BOX oxide film was formed with a vertical furnace (with a 100 percent oxygen atmosphere within the furnace) by increasing the temperature from 700°C to 800°C at 5°C/minute, maintaining 800°C for 6 minutes, and then decreasing the temperature to 700°C at 2.5°C/minute.

### [Comparative Example 2]

A bonded wafer was prepared by the same method as in Example 3 with the exception that a BOX oxide film was formed with a vertical furnace (with a 100 percent oxygen atmosphere within the furnace) by increasing the temperature from 700°C to 800°C at 5°C/minute, maintaining 800°C for 6 minutes, and then decreasing the temperature to 700°C at 2.5°C/minute.

### [Comparative Example 3]

A bonded wafer was prepared by the same method as in Example 5 with the exception that a BOX oxide film was formed with a vertical furnace (with a 100 percent oxygen atmosphere within the furnace) by increasing the temperature from 700°C to 800°C at 5°C/minute, maintaining 800°C for 6 minutes, and then decreasing the temperature to 700°C at 2.5°C/minute.

**[Table 1]**

| | Oxygen concentration of base wafer (× E + 17/cm³) | Heating temp. (°C) | Average film thickness (nm) | Film Thickness Range (nm) | BMD density (/cm²) |
|---|---|---|---|---|---|
| Ex.1 | 12 | 900 | 2.1 | 0.22 | 9.76E+02 |
| Ex. 2 | | 1100 | 2.3 | 0.23 | 1.43E+02 |
| Comp.Ex.1 | | 800 | 2.2 | 0.25 | 9.42E+03 |
| Ex. 3 | 13 | 900 | 2.3 | 0.24 | 2.60E+04 |
| Ex. 4 | | 1100 | 2.0 | 0.22 | 3.48E+03 |
| Comp.Ex.2 | | 800 | 2.4 | 0.26 | 2.20E+05 |
| Ex. 5 | 14 | 900 | 2.2 | 0.26 | 1.24E+05 |
| Ex. 6 | | 1100 | 2.2 | 0.23 | 1.53E+04 |
| Comp.Ex.3 | | 800 | 2.1 | 0.28 | 9.54E+05 |

A comparison of Examples and Comparative Examples having base wafers of identical oxygen concentration in Table 1 reveals that oxidation treatment comprising heating to 800 to 1,300°C at a rate of temperature increase of 50 to 100°C/second permitted the rapid formation of oxide films of uniform thickness and permitted a reduction of the BMD density in the base wafer.

### [Example 7]

The bonded wafer prepared in Example 1 was heat treated for 60 minutes at 1,200°C in an argon atmosphere. Cross-sections of the wafer were evaluated before and after the heat treatment by transmission electron microscopy (TEM). The TEM image obtained is shown in Fig. 1. As indicated in Fig. 1, the above treatment removed the BOX oxide film, yielding a DSB wafer.

The present invention permits the manufacturing of high-quality SOI wafers and DSB wafers.

Although the present invention has been described in considerable detail with regard to certain versions thereof, other versions are possible, and alterations, permutations and equivalents of the version shown will become apparent to those skilled in the art upon a reading of the specification and study of the drawings. Also, the various features of the versions herein can be combined in various ways to provide additional versions of the present invention. Furthermore, certain terminology has been used for the purposes of descriptive clarity, and not to limit the present invention.

Additionally, the recitation of numerical ranges within this specification is considered to be a disclosure of all numerical values and ranges within that range. For example, if a range is from about 1 to about 50, it is deemed to include, for example, 1, 7, 34, 46.1, 23.7, or any other value or range within the range.

## Claims

1. A method of manufacturing a bonded silicon wafer comprising:
forming an oxide film on at least one surface of a base wafer through oxidation,
bonding the base wafer on which the oxide film has been formed to a top wafer to form a bonded wafer, wherein the oxygen concentration for the base wafer and the top wafer is 8 x E+17 to 14 x E+17 atoms/cm³, and
thinning the top wafer included in the bonded wafer, wherein the oxidation comprises heating the base wafer to a heating temperature ranging from 800 to 1300 °C at a rate of temperature increase ranging from 50 to 100 °C/second in an oxidizing atmosphere, and
wherein the bonding is carried out so as to position the oxide film formed in the oxidation at an interface of the top wafer and the base wafer.

2. The method of manufacturing a bonded wafer of claim 1, wherein the oxidation is carried out in a Rapid Thermal Processor.

3. The method of manufacturing a bonded wafer of claim 1 or 2, wherein the oxidation is carried out so as to form an oxide film on at least one surface of the base wafer so that the total thickness of the oxide film position at the interface is equal to or less than 30 nm.

4. The method of manufacturing a bonded wafer of any of claims 1 to 3, wherein the heating temperature in the oxidation ranges from 1000 to 1200 °C.

5. The method of manufacturing a bonded wafer of any of claims 1 to 4, wherein the oxidation comprises holding the base wafer for 1 to 3 minutes at the heating temperature.

6. The method of manufacturing a bonded wafer of any of claims 1 to 5, wherein the oxidation further comprises lowering a temperature at a rate of temperature reduction ranging from 50 to 100 °C/second.

7. The method of manufacturing a bonded wafer of any of claims 1 to 6, wherein the thinning is conducted by, prior to the bonding, implanting light element ions into a top wafer to form an ion implantation layer in the top wafer, and following the bonding, subjecting the bonded wafer to heat treatment to separate a portion of the top wafer from the bonded wafer at the ion implantation layer as boundary.

8. The method of manufacturing a bonded wafer of any of claims 1 to 6, wherein the thinning is conducted by, prior to the bonding, implanting oxygen ions into a top wafer to form an ion implantation layer in the top wafer, and following the bonding, removing a portion of the top wafer from the bonded wafer at the ion implantation layer as boundary by grinding, polishing and/or etching.

9. The method of manufacturing a bonded wafer of any of claims 1 to 8, which further comprises removing the oxide film present at the interface by subjecting the bonded wafer to heat treatment in a non-oxidizing atmosphere.

## Patentansprüche

1. Verfahren zur Herstellung eines gebondeten Siliciumwafers, umfassend:
Bilden einer Oxidschicht auf wenigstens einer Oberfläche eines Basiswafers durch Oxidation,
Bonden des Basiswafers, auf welchem die Oxidschicht gebildet wurde, an einen Top-Wafer, um einen gebondeten Wafer zu bilden, wobei die Sauerstoff-Konzentration für den Basiswafer und den Top-Wafer 8 × E+17 bis 14 × E+17 Atome/cm³ beträgt, und
Dünnen des im gebondeten Wafer enthaltenen Top-Wafers, wobei die Oxidation das Erhitzen des Basiswafers auf eine Heiztemperatur im Bereich von 800 bis 1300 °C umfasst, bei einer Geschwindigkeit der Temperaturerhöhung im Bereich von 50 bis 100 °C pro Sekunde in einer oxidierenden Atmosphäre, und wobei das Bonden auf eine Weise ausgeführt wird, um die bei der Oxidation gebildete Oxidschicht an einer Schnittstelle des Top-Wafers und des Basiswafers zu positionieren.

2. Verfahren zur Herstellung eines gebondeten Wafers nach Anspruch 1, wobei die Oxidation in einem Schnellheizbehandlungssystem (Rapid Thermal Processor) erfolgt.

3. Verfahren zur Herstellung eines gebondeten Wafers nach Anspruch 1 oder 2, wobei die Oxidation auf eine Weise durchgeführt wird, dass eine Oxidschicht gebildet wird an wenigstens einer Oberfläche des Basiswafers, sodass die Gesamtdicke der Oxidschicht an der Schnittstelle gleich oder kleiner 30 nm ist.

4. Verfahren zur Herstellung eines gebondeten Wafers nach einem der Ansprüche 1 bis 3, wobei die Heiztemperatur während der Oxidation im Bereich von 1000 bis 1200 °C liegt.

5. Verfahren zur Herstellung eines gebondeten Wafers nach einem der Ansprüche 1 bis 4, wobei die Oxidation umfasst, dass der Basiswafer für 1 bis 3 Minuten bei der Heiztemperatur gehalten wird.

6. Verfahren zur Herstellung eines gebondeten Wafers nach einem der Ansprüche 1 bis 5, wobei die Oxidation ferner das Absenken einer Temperatur bei einer Geschwindigkeit der Temperaturverringerung im Bereich von 50 bis 100 °C pro Sekunde umfasst.

7. Verfahren zur Herstellung eines gebondeten Wafers nach einem der Ansprüche 1 bis 6, wobei das Dünnen vor dem Bonden durchgeführt wird durch Implantieren von Leichtelement-Ionen in einen Top-Wafer, um eine lonenimplantationsschicht im Top-Wafer zu bilden, und, nach dem Bonden, der gebondete Wafer einer Wärmebehandlung unterworfen wird, um einen Teil des Top-Wafers vom gebondeten Wafer an der lonenimplantationsschicht als Grenze abzutrennen.

8. Verfahren zur Herstellung eines gebondeten Wafers nach einem der Ansprüche 1 bis 6, wobei das Dünnen vor dem Bonden ausgeführt wird durch Implantieren von Sauerstoff-Ionen in einen Top-Wafer, um eine Ionenimplantationsschicht im Top-Wafer zu bilden, und, nach dem Bonden, ein Teil des Top-Wafers vom gebondeten Wafer an der Ionenimplantationsschicht als Grenze entfernt wird durch Schleifen, Polieren und/oder Ätzen.

9. Verfahren zur Herstellung eines gebondeten Wafers nach einem der Ansprüche 1 bis 8, weiches ferner das Entfernen der Oxidschicht umfasst, welche sich an der Schnittstelle befindet, durch Unterwerfen des gebondeten Wafers einer Wärmebehandlung in einer nicht-oxidierenden Atmosphäre.

## Revendications

1. Procédé de fabrication d'une tranche de silicium collée comprenant :
la formation d'un film d'oxyde sur au moins une surface d'une tranche de base par oxydation,
le collage de la tranche de base sur laquelle le film d'oxyde a été formé à une tranche de dessus pour former une tranche collée, dans lequel la concentration en oxygène pour la tranche de base et la tranche de dessus est de 8 x E + 17 à 14 x E + 17 atomes/cm³, et
l'amincissement de la tranche de dessus incluse dans la tranche collée, dans lequel l'oxydation comprend le chauffage de la tranche de base à une température de chauffage valant de 800 à 1 300 °C à une cadence d'augmentation de température allant de 50 à 100 °C/seconde dans une atmosphère oxydante, et dans lequel le collage est réalisé de façon à positionner le film d'oxyde formé lors de l'oxydation au niveau d'une interface entre la tranche de dessus et la tranche de base.

2. Procédé de fabrication d'une tranche collée selon la revendication 1, dans lequel l'oxydation est réalisée dans un organe de traitement thermique rapide.

3. Procédé de fabrication d'une tranche collée selon la revendication 1 ou 2, dans lequel l'oxydation est réalisée de façon à former un film d'oxyde sur au moins une surface de la tranche de base de sorte que l'épaisseur totale de la position de film d'oxyde au niveau de l'interface soit inférieure ou égale à 30 nm.

4. Procédé de fabrication d'une tranche collée selon l'une quelconque des revendications 1 à 3, dans lequel la température de chauffage lors de l'oxydation vaut de 1 000 à 1 200 °C.

5. Procédé de fabrication d'une tranche collée selon l'une quelconque des revendications 1 à 4, dans lequel l'oxydation comprend le maintien de la tranche de base pendant 1 à 3 minutes à la température de chauffage.

6. Procédé de fabrication d'une tranche collée selon l'une quelconque des revendications 1 à 5, dans lequel l'oxydation comprend en outre l'abaissement d'une température à une cadence de réduction de température valant de 50 à 100 °C/seconde.

7. Procédé de fabrication d'une tranche collée selon l'une quelconque des revendications 1 à 6, dans lequel l'amincissement est effectué, avant le collage, en implantant des ions d'élément léger dans une tranche de dessus pour former une couche d'implantation ionique dans la tranche de dessus, et suite au collage, en soumettant la tranche collée à un traitement à la chaleur pour séparer une portion de la tranche de dessus de la tranche collée au niveau de la couche d'implantation ionique en tant que frontière.

8. Procédé de fabrication d'une tranche collée selon l'une quelconque des revendications 1 à 6, dans lequel l'amincissement est effectué, avant le collage, en implantant des ions oxygène dans une tranche de dessus pour former une couche d'implantation ionique dans la tranche de dessus, et suite au collage, en éliminant une portion de la tranche de dessus de la tranche collée au niveau de la couche d'implantation ionique en tant que frontière par meulage, polissage et/ou gravure.

9. Procédé de fabrication d'une tranche collée selon l'une quelconque des revendications 1 à 8, qui comprend en outre l'élimination du film d'oxyde présent au niveau de l'interface en soumettant la tranche collée à un traitement à la chaleur dans une atmosphère non oxydante.
